# EUROPEAN PATENT APPLICATION

(11) **EP 4 811 944 A1**
(43) Date of publication of application: **23.09.2026**
(21) Application number: 24902433.2
(22) Date of filing: 05.11.2024
(51) Int. Cl.: H05K 7/20

(54) **HEAT DISSIPATION ARCHITECTURE, CHASSIS, NETWORK DEVICE AND COMMUNICATIONS SYSTEM**

(30) Priority: 15.12.2023 CN 202323436957 U
(71) Applicant: Huawei Technologies Co., Ltd., Shenzhen, Guangdong 518129 (CN)
(72) Inventor: LI, Jiang, Shenzhen, Guangdong 518129 (CN); LI, Chenjing, Shenzhen, Guangdong 518129 (CN); ZHAN, Ce, Shenzhen, Guangdong 518129 (CN)
(74) Representative: Gill Jennings & Every LLP
(86) International application number: PCT/CN2024/129913
(87) International publication number: WO 2025/124009

(57) **Abstract**

Embodiments of this application provide a heat dissipation architecture, a subrack, a network device, and a communication system, relating to the field of communication technologies, to meet heat dissipation requirements both before and after network upgrades while reducing costs. The heat dissipation architecture includes a heat dissipation frame body, at least one limiting member, and at least one fan tray. The heat dissipation frame body has a heat dissipation cavity. The heat dissipation frame body includes a first cavity wall and a second cavity wall that are disposed opposite to each other. The heat dissipation frame body is provided with a first air vent that communicates with the heat dissipation cavity. The limiting member is located in the heat dissipation cavity, and the limiting member is disposed on the first cavity wall. A first accommodating cavity is formed between the second cavity wall and a surface of a side of the limiting member facing away from the first cavity wall. The limiting member divides the heat dissipation cavity into a second accommodating cavity and a third accommodating cavity along an extension direction of the limiting member. The fan tray is located in the heat dissipation cavity, and an air port of the fan tray faces the first air vent. The fan tray is slidably engaged with the limiting member along an extension direction of the limiting member.

## Description

This application claims priority to Chinese Patent Application No. 202323436957.4, filed with the China National Intellectual Property Administration on December 15, 2023 and entitled "HEAT DISSIPATION ARCHITECTURE, SUBRACK, NETWORK DEVICE, AND COMMUNICATION SYSTEM", which is incorporated herein by reference in its entirety.

### TECHNICAL FIELD

The present utility model relates to the field of communication technologies, and in particular, to a heat dissipation architecture, a subrack, a network device, and a communication system.

### BACKGROUND

Subracks are mainly used in network devices such as optical access central office equipment, switches, data centers, and servers, for operations such as processing and distributing data or signals.

With the development of the era of massive data, requirements for high-bandwidth transmission and high-performance computing continue to grow. After being deployed in the network devices, subracks evolve as the workload of the network devices changes. As subracks evolve, networks gradually upgrade, power consumption of the subracks increases, and the requirements for heat dissipation capability also rise. Therefore, a heat dissipation architecture that can adapt to the evolution of subracks is urgently needed to meet heat dissipation requirements while reducing costs.

### SUMMARY

An objective of this application is to provide a heat dissipation architecture, a subrack, a network device, and a communication system that can meet heat dissipation requirements both before and after network upgrades while reducing costs.

To achieve the foregoing objectives, the following technical solutions are used in embodiments of this application.

According to a first aspect of embodiments of this application, a heat dissipation architecture is provided. The heat dissipation architecture includes: a heat dissipation frame body, at least one limiting member, and at least one fan tray. The heat dissipation frame body has a heat dissipation cavity. The heat dissipation frame body includes a first cavity wall and a second cavity wall that are disposed opposite to each other. The heat dissipation frame body is provided with a first air vent that communicates with the heat dissipation cavity. The limiting member is located in the heat dissipation cavity, and the limiting member is disposed on the first cavity wall. A first accommodating cavity is formed between the second cavity wall and a surface of a side of the limiting member facing away from the first cavity wall. The limiting member divides the heat dissipation cavity into a second accommodating cavity and a third accommodating cavity along an extension direction of the limiting member. The fan tray is located in the heat dissipation cavity, and an air port of the fan tray faces the first air vent. The fan tray is slidably engaged with the limiting member along an extension direction of the limiting member.

It can be learned from the foregoing that the heat dissipation frame body of the heat dissipation architecture has the heat dissipation cavity, and the fan tray may be disposed in the heat dissipation cavity. The air port of the fan tray faces the first air vent provided in the heat dissipation frame body, so that the air port of the fan tray and the first air vent can ventilate each other to implement heat dissipation. In addition, the heat dissipation architecture further includes the limiting member. The limiting member is disposed on the first cavity wall, and the first accommodating cavity is formed between the second cavity wall and the surface of the side of the limiting member facing away from the first cavity wall. In addition, the limiting member divides the heat dissipation cavity into the second accommodating cavity and the third accommodating cavity along the extension direction of the limiting member. In this case, the fan tray may be disposed in the first accommodating cavity. Alternatively, the fan tray may be disposed in the second accommodating cavity or the third accommodating cavity. Alternatively, a part of the fan tray may be disposed in the second accommodating cavity, and the other part may be disposed in the third accommodating cavity. When heat dissipation requirements are low, one fan tray may be disposed in the first accommodating cavity in the heat dissipation architecture. In this case, in a direction parallel to the first cavity wall and perpendicular to the extension direction of the limiting member, the limiting member does not prevent the fan tray from being disposed in the first accommodating cavity. A size of the fan tray can be large, so that the heat dissipation requirements are met in this case. Costs of disposing one fan tray is lower than that of disposing a plurality of fan trays, so that costs before network upgrades are reduced. However, when the heat dissipation architecture includes only one fan tray, when the fan tray fails or needs to be maintained, the fan tray needs to stop operating and be taken out for repair and maintenance. Because the heat dissipation architecture temporarily loses a heat dissipation function, in this case, the heat dissipation architecture cannot meet high heat dissipation requirements. After network upgrades, when heat dissipation requirements are high, two fan trays that are independent of each other may be disposed in the first accommodating cavity and the second accommodating cavity in the heat dissipation architecture. When one of the fan trays needs to be repaired or maintained, another fan tray continues to operate, so that it is ensured that the heat dissipation architecture does not completely lose a heat dissipation function, to meet the high heat dissipation requirements. In addition, power consumption of the two fan trays may be separately adjusted with reference to heat dissipation requirements of different areas, to meet heat dissipation requirements and optimize overall power consumption. In this way, heat dissipation requirements can be met both before and after network upgrades, and costs are reduced.

In some embodiments of this application, the at least one limiting member includes a first limiting member, and the first limiting member divides the heat dissipation cavity into the second accommodating cavity and the third accommodating cavity along an extension direction of the first limiting member; and the at least one fan tray includes a first fan tray and a second fan tray. The first fan tray is disposed in the second accommodating cavity, and a surface of a side of the first fan tray facing the third accommodating cavity is slidably engaged with the first limiting member. The second fan tray is disposed in the third accommodating cavity, and a surface of a side of the second fan tray facing the second accommodating cavity is slidably engaged with the first limiting member. A first gap exists between the first fan tray and the second fan tray, and the first limiting member is located in the first gap. It can be learned from the foregoing that the first limiting member is located in the first gap between the first fan tray and the second fan tray, and both the first fan tray and the second fan tray slidably fit with the first limiting member. In this case, in a direction perpendicular to the extension direction of the first limiting member and parallel to the first cavity wall, the first limiting member can separately limit the first fan tray and the second fan tray, and both the first fan tray and the second fan tray can slide only along the extension direction of the first limiting member, so that the first limiting member can guide sliding of the first fan tray and the second fan tray. This ensures that both the first fan tray and the second fan tray can be installed in expected positions.

In some embodiments of this application, the at least one limiting member may further include a second limiting member, the second limiting member is located in the third accommodating cavity, and the second limiting member divides the third accommodating cavity into a fourth accommodating cavity and a fifth accommodating cavity along an extension direction of the second limiting member. The second fan tray is located in the fourth accommodating cavity, and a surface of a side of the second fan tray facing the fifth accommodating cavity is slidably engaged with the second limiting member. The at least one fan tray further includes a third fan tray, the third fan tray is located in the fifth accommodating cavity, and a surface of a side of the third fan tray facing the fourth accommodating cavity is slidably engaged with the second limiting member. A second gap exists between the second fan tray and the third fan tray, and the second limiting member is located in the second gap. It can be learned from the foregoing that the first limiting member and the second limiting member divide the heat dissipation cavity into the second accommodating cavity, the fourth accommodating cavity, and the fifth accommodating cavity along the extension direction of the first limiting member and the second limiting member. The second fan tray is disposed in the fourth accommodating cavity, and is limited and guided through the second limiting member. The second limiting member guides sliding of the second fan tray. The third fan tray is disposed in the fifth accommodating cavity, and is limited and guided through the second limiting member. The second limiting member guides sliding of the third fan tray. This ensures that the second fan tray and the third fan tray can be installed in expected positions when the fan tray needs to be replaced with a plurality of fan trays after network upgrades.

In some embodiments of this application, the at least one limiting member may include a first limiting member, and the first limiting member divides the heat dissipation cavity into the second accommodating cavity and the third accommodating cavity along an extension direction of the first limiting member. The at least one fan tray may include the first fan tray and the second fan tray. The first fan tray is disposed in the second accommodating cavity. A side of the first fan tray facing the first cavity wall is provided with a first sliding groove. The first limiting member is located in and engaged with the first sliding groove. The second fan tray is disposed in the third accommodating cavity. The surface of the side of the second fan tray facing the second accommodating cavity is slidably engaged with the first limiting member. In this case, the first limiting member is located in the first sliding groove of the first fan tray, and the first limiting member is engaged with the first sliding groove, so that the first fan tray can slide only along the extension direction of the first limiting member. In this way, the first limiting member limits and guides the first fan tray, to ensure that the first fan tray can be installed at an expected position. In addition, the first limiting member is located in the first sliding groove. In this case, a gap between a surface of the first fan tray facing the second fan tray and a surface of the second fan tray facing the first fan tray may be small or there may even be no gap. In this case, space occupied by the first fan tray and the second fan tray in the heat dissipation cavity is large, thereby improving space utilization of the heat dissipation cavity.

In some embodiments of this application, the surface of the first fan tray facing the second fan tray abuts against the surface of the second fan tray facing the first fan tray. In this case, apart from the first sliding groove used to accommodate the first limiting member, there is no other gap between the first fan tray and the second fan tray, so that space occupied by the first fan tray and the second fan tray in the heat dissipation cavity is further increased, thereby further improving space utilization of the heat dissipation cavity.

In some embodiments of this application, the at least one limiting member includes the first limiting member, and the first limiting member divides the heat dissipation cavity into the second accommodating cavity and the third accommodating cavity along the extension direction of the first limiting member. The at least one fan tray includes the first fan tray and the second fan tray. The first fan tray is disposed in the second accommodating cavity, and the side of the first fan tray facing the first cavity wall is provided with a first recess portion. The second fan tray is disposed in the third accommodating cavity, and the side of the second fan tray facing the first cavity wall is provided with a second recess portion. The first recess portion and the second recess portion collectively form a second sliding groove. The first limiting member is located in and engaged with the second sliding groove. This embodiment is similar to the embodiment in which the side of the first fan tray facing the first cavity wall is provided with the first sliding groove. In this case, the first limiting member is located in the second sliding groove collectively formed by the first recess portion of the first fan tray and the second recess portion of the second fan tray, and the first limiting member is engaged with the second sliding groove. The first limiting member may separately guide sliding of the first fan tray and sliding of the second fan tray, to ensure that both the first fan tray and the second fan tray can be installed in expected positions.

In some embodiments of this application, the at least one limiting member may include the first limiting member and the second limiting member. The first limiting member divides the heat dissipation cavity into the second accommodating cavity and the third accommodating cavity along the extension direction of the first limiting member. The second limiting member is located in the third accommodating cavity, and the second limiting member divides the third accommodating cavity into the fourth accommodating cavity and the fifth accommodating cavity along the extension direction of the second limiting member. The at least one fan tray may include the first fan tray and the second fan tray. The first fan tray is disposed in the second accommodating cavity and the fourth accommodating cavity, and is located between the first limiting member and the second cavity wall. The first fan tray is slidably engaged with a surface of the first limiting member facing the second cavity wall. The second fan tray is disposed in the fourth accommodating cavity and the fifth accommodating cavity, and is located between the second limiting member and the second cavity wall. The second fan tray is slidably engaged with a surface of the second limiting member facing the second cavity wall. It can be learned from the foregoing that, a part of the first fan tray is disposed in the second accommodating cavity, and the other part is disposed in the fourth accommodating cavity, and is slidably engaged with the first limiting member. In this case, the first fan tray can slide on the surface of the first limiting member facing the second cavity wall, to implement installation and removal of the first fan tray. In addition, a part of the second fan tray is disposed in the fourth accommodating cavity, and the other part is disposed in the fifth accommodating cavity, and is slidably engaged with the second limiting member. Similarly, the second fan tray can slide on the surface of the second limiting member facing the second cavity wall, to implement installation and removal of the second fan tray.

In some embodiments of this application, the side of the first fan tray facing the first cavity wall is provided with a third sliding groove. The first limiting member is located in and engaged with the third sliding groove. The side of the second fan tray facing the first cavity wall is provided with a fourth sliding groove. The second limiting member is located in and engaged with the fourth sliding groove. It can be learned from the foregoing that the first limiting member is located in the third sliding groove of the first fan tray, and is engaged with the third sliding groove. In this case, in the direction perpendicular to the extension direction of the first limiting member and parallel to the first cavity wall, the first limiting member can limit the first fan tray, so that the first limiting member can guide sliding of the first fan tray. Similarly, the second limiting member is located in the fourth sliding groove of the second fan tray, and is engaged with the fourth sliding groove. The second limiting member can also limit and guide the second fan tray, so that the second limiting member can guide sliding of the second fan tray. This ensures that both the first fan tray and the second fan tray can be installed in expected positions.

In some embodiments of this application, the fan tray is disposed in the first accommodating cavity. Before network upgrades, only one fan tray may be installed in the heat dissipation cavity, to meet low heat dissipation requirements before network upgrades while reducing costs.

In some embodiments of this application, the fan tray may include a first part and a second part. The first part is disposed in the first accommodating cavity. A side of the second part facing the first cavity wall is provided with a fifth sliding groove, and the limiting member is located in and engaged with the fifth sliding groove. In this case, the second part of the fan tray is located between the first cavity wall and the surface of the side of the limiting member facing away from the first cavity wall. This case is different from a case in which the entire fan tray is disposed in the first accommodating cavity in that the fan tray occupies large space in the heat dissipation cavity. This improves space utilization of the heat dissipation cavity.

In some embodiments of this application, the fan tray may include a first fan assembly and a second fan assembly, and sides of the first fan assembly and the second fan assembly facing away from the heat dissipation cavity are connected to each other. A third gap exists between the first fan assembly and the second fan assembly. The limiting member is located in the third gap. In this case, the limiting member is located in the third gap between the first fan assembly and the second fan assembly, and the limiting member does not prevent the first fan assembly and the second fan assembly from being installed in the heat dissipation cavity. In this way, it is ensured that only one fan tray with a large size may be installed in the heat dissipation cavity before network upgrades, to meet low heat dissipation requirements before network upgrades.

According to a second aspect of embodiments of this application, a heat dissipation architecture is provided. The heat dissipation architecture includes a heat dissipation frame body and at least one limiting member. The heat dissipation frame body has a heat dissipation cavity. The heat dissipation frame body includes a first cavity wall and a second cavity wall that are disposed opposite to each other. The heat dissipation frame body is provided with a first air vent that communicates with the heat dissipation cavity. The limiting member is located in the heat dissipation cavity, and the limiting member is disposed on the first cavity wall. A first accommodating cavity is formed between the second cavity wall and a surface of a side of the limiting member facing away from the first cavity wall. The limiting member divides the heat dissipation cavity into a second accommodating cavity and a third accommodating cavity along an extension direction of the limiting member. The foregoing heat dissipation architecture has same technical effect as the heat dissipation architecture provided in the foregoing embodiment, and details are not described herein again.

According to a third aspect of embodiments of this application, a heat dissipation architecture is provided. The heat dissipation architecture includes a heat dissipation frame body and at least one limiting member. The heat dissipation frame body has a heat dissipation cavity. The heat dissipation frame body includes a first cavity wall and a second cavity wall that are disposed opposite to each other. The heat dissipation frame body is provided with a first air vent that communicates with the heat dissipation cavity. The limiting member is located in the heat dissipation cavity. The limiting member is detachably connected to the first cavity wall, and the limiting member divides the heat dissipation cavity into a second accommodating cavity and a third accommodating cavity along an extension direction of the limiting member. It can be learned from the foregoing that the limiting member can be detached from the first cavity wall. Before network upgrades, heat dissipation requirements are low. After the limiting member is detached from the first cavity wall, a large fan tray can be installed in the heat dissipation cavity. After network upgrades, heat dissipation requirements are high. After the limiting member is installed on the first cavity wall, the limiting member may divide the heat dissipation cavity into the second accommodating cavity and the third accommodating cavity. Two independent fan trays may be disposed in the second accommodating cavity and the third accommodating cavity respectively, to ensure that the fan trays can be repaired or maintained one by one, and ensure that at least one fan tray is in an operating state, to meet the heat dissipation requirements. In this way, heat dissipation requirements can be met before and after network upgrades, and costs are reduced.

According to a fourth aspect of embodiments of this application, a heat dissipation architecture is provided. The heat dissipation architecture includes a heat dissipation frame body, at least one limiting member, and a fan tray. The heat dissipation frame body has a heat dissipation cavity. The heat dissipation frame body includes a first cavity wall and a second cavity wall that are disposed opposite to each other. The heat dissipation frame body is provided with a first air vent that communicates with the heat dissipation cavity. The limiting member is located in the heat dissipation cavity. A first end of the limiting member is fixedly connected to the first cavity wall, and a second end of the limiting member is connected to the second cavity wall. The limiting member divides the heat dissipation cavity into a second accommodating cavity and a third accommodating cavity along an extension direction of the limiting member. The fan tray is located in the heat dissipation cavity, and the fan tray includes a first fan assembly and a second fan assembly. Sides of the first fan assembly and the second fan assembly facing away from the heat dissipation cavity are connected to each other, and a third gap exists between the first fan assembly and the second fan assembly. The limiting member is located in the third gap. In this case, the first end of the limiting member is fixedly connected to the first cavity wall, the second end of the limiting member is connected to the second cavity wall, and the limiting member is fastened securely, to ensure stability of connection between the limiting member and the heat dissipation frame body. In addition, the limiting member is located in the third gap between the first fan assembly and the second fan assembly. The limiting member does not prevent the first fan assembly and the second fan assembly from being installed in the heat dissipation cavity. In this way, it is ensured that only one fan tray with a large size may be installed in the heat dissipation cavity before network upgrades, to meet low heat dissipation requirements before network upgrades. After network upgrades, the fan tray may be replaced with two independent fan trays, and the two independent fan trays are installed in the second accommodating cavity and the third accommodating cavity respectively, to ensure that the fan trays can be repaired or maintained one by one, and ensure that at least one fan tray is in an operating state to meet the heat dissipation requirements. In this way, heat dissipation requirements can be met before and after network upgrades, and costs are reduced.

According to a fifth aspect of embodiments of this application, a subrack is provided, where the subrack includes the heat dissipation architecture described in any one of the foregoing embodiments, and the subrack further includes a frame and a plurality of boards. Both the heat dissipation architecture and the board are disposed in the frame. In addition, each board is located on a same side of the heat dissipation architecture, a heat dissipation gap exists between adjacent boards, and the heat dissipation gap communicates with the first air vent. It can be learned from the foregoing that the heat dissipation gap communicates with the first air vent. For example, through air intake from the heat dissipation gap via the first air vent, the heat dissipation architecture enables air at the heat dissipation gap to flow to the first air vent, thereby reducing a temperature in the heat dissipation gap. Alternatively, through air exhaust to the heat dissipation gap through the first air vent, the heat dissipation architecture enables air in the heat dissipation gap to flow, thereby taking away heat of the heat dissipation gap, and thus implementing a heat dissipation function. In addition, the foregoing subrack further has same technical effect as the heat dissipation architecture provided in any one of the foregoing embodiments, and details are not described herein again.

According to a sixth aspect of embodiments of this application, a network device is provided. The network device includes one or more subracks. The foregoing network device has same technical effect as the subrack provided in the foregoing embodiment, and details are not described herein again.

According to a seventh aspect of embodiments of this application, a communication system is provided. The communication system includes the foregoing network device, the communication system further includes a first access device, and the first access device is connected to the network device. The foregoing communication system has same technical effect as the subrack provided in the foregoing embodiment, and details are not described herein again.

### BRIEF DESCRIPTION OF DRAWINGS

FIG. 1 is a diagram of a structure of a communication system according to an embodiment of this application;
FIG. 2 is a diagram of another structure of a communication system according to an embodiment of this application;
FIG. 3A is a diagram of a structure of a subrack in which one fan tray is disposed according to an embodiment of this application;
FIG. 3B is a diagram of a structure of a subrack in which a plurality of fan trays are disposed according to an embodiment of this application;
FIG. 3C is a diagram of a structure of a subrack from which a fan tray is detached according to an embodiment of this application;
FIG. 3D is a diagram of another structure of a subrack from which a fan tray is detached according to an embodiment of this application;
FIG. 4A is a main view of a first subrack according to an embodiment of this application;
FIG. 4B is a main view of a second subrack according to an embodiment of this application;
FIG. 4C is a main view of a third subrack according to an embodiment of this application;
FIG. 4D is a main view of a fourth subrack according to an embodiment of this application;
FIG. 4E is a top view of a fifth subrack according to an embodiment of this application;
FIG. 4F is a top view of a sixth subrack according to an embodiment of this application;
FIG. 5A is a diagram of assembling of a heat dissipation frame body and a limiting member according to an embodiment of this application;
FIG. 5B is a main view of FIG. 5A;
FIG. 5C is another main view of FIG. 5A;
FIG. 6 is a diagram of a structure of a fan tray according to an embodiment of this application;
FIG. 7 is another diagram of assembling of a heat dissipation frame body and a limiting member according to an embodiment of this application;
FIG. 8 is a diagram of a structure of a first heat dissipation architecture according to an embodiment of this application;
FIG. 9 is still another diagram of assembling of a heat dissipation frame body and a limiting member according to an embodiment of this application;
FIG. 10 is a diagram of a structure of a second heat dissipation architecture according to an embodiment of this application;
FIG. 11 is a diagram of a structure of a third heat dissipation architecture according to an embodiment of this application;
FIG. 12 is a diagram of a structure of a fourth heat dissipation architecture according to an embodiment of this application;
FIG. 13 is a diagram of a structure of a fifth heat dissipation architecture according to an embodiment of this application;
FIG. 14 is a diagram of a structure of a sixth heat dissipation architecture according to an embodiment of this application;
FIG. 15 is a diagram of a structure of a seventh heat dissipation architecture according to an embodiment of this application;
FIG. 16 is a diagram of a structure of an eighth heat dissipation architecture according to an embodiment of this application;
FIG. 17 is a diagram of a structure of a ninth heat dissipation architecture according to an embodiment of this application;
FIG. 18 is a diagram of a structure of a tenth heat dissipation architecture according to an embodiment of this application;
FIG. 19 is a diagram of a structure of an eleventh heat dissipation architecture according to an embodiment of this application;
FIG. 20 is a diagram of another structure of a fan tray according to an embodiment of this application; and
FIG. 21 is a diagram of a structure of a twelfth heat dissipation architecture according to an embodiment of this application.

### Reference numerals:

01: communication system; 02: network device; 10: subrack; 11: heat dissipation architecture; 111: heat dissipation frame body; 1111: heat dissipation cavity; 11111: first accommodating cavity; 11112: second accommodating cavity; 11113: third accommodating cavity; 111131: fourth accommodating cavity; 111132: fifth accommodating cavity; 1111321: sixth accommodating cavity; 1111322: seventh accommodating cavity; 1112: first air vent; 1113: first cavity wall; 1114: second cavity wall; 1115: second air vent; 112: limiting member; 1121: first end; 1122: second end; a1: first limiting member; a2: second limiting member; a3: third limiting member; 113: fan tray; 1131: air port; 1132: first part; 1133: second part; 11331: fifth sliding groove; 1134: first fan assembly; 1135: second fan assembly; 1136: third gap; b1: first fan tray; b11: first sliding groove; b12: first recess portion; b13: third sliding groove; b2: second fan tray; b21: second recess portion; b22: sixth sliding groove; b23: third recess portion; b24: fourth sliding groove; b3: third fan tray; b31: fourth recess portion; b32: eighth sliding groove; b4: fourth fan tray; 114: first gap; 115: second gap; 116: second sliding groove; 117: seventh sliding groove; 12: frame; 13: board; 14: heat dissipation gap; 15: back plate; 16: connector; 20: distribution frame; 03: first access device; 04: second access device.

### DESCRIPTION OF EMBODIMENTS

The following describes technical solutions in embodiments of this application with reference to accompanying drawings in embodiments of this application. It is clear that the described embodiments are merely some but not all of embodiments of this application.

The following terms "first", "second", "third", "fourth", "fifth", "sixth", "seventh", "eighth", and the like are merely used for ease of description, and shall not be understood as an indication or implication of relative importance or implicit indication of a quantity of indicated technical features. Therefore, a feature defined by "first", "second", "third", "fourth", "fifth", "sixth", "seventh", "eighth", or the like may explicitly or implicitly include one or more features. In the descriptions of this application, unless otherwise stated, "a plurality of" means two or more.

In this application, unless otherwise specified and limited, the term "connection" should be understood in a broad sense. For example, the "connection" may be an electrical connection or an optical fiber connection; or the "connection" may be a fixed mechanical connection, a detachable mechanical connection, or an integrated connection; or the "connection" may be a direct connection, or may be an indirect connection through an intermediate medium.

In embodiments of this application, the term such as "for example" represents giving an example, an illustration, or a description. Any embodiment or design solution described as an "example" in embodiments of this application should not be explained as being more preferred or having more advantages than another embodiment or design solution. Exactly, use of the term such as "example" is intended to present a related concept in a specific manner.

In the accompanying drawings of embodiments of this application, an assembly is represented by a guide line with an arrow, a component is represented by only a guide line, and a hollow structure like an opening or a hole is represented by a guide line with a hollow circle at an end.

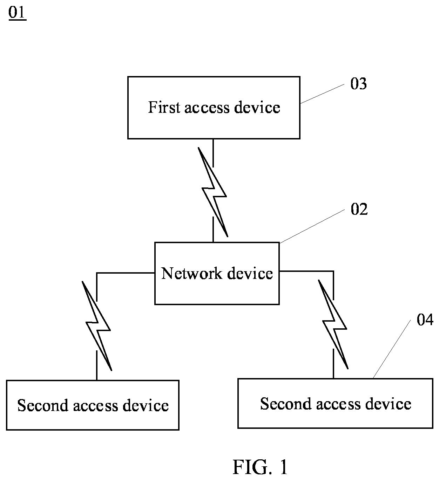

An embodiment of this application provides a communication system 01. As shown in FIG. 1, the communication system 01 may include a network device 02 and a first access device 03 connected to the network device 02. The first access device 03 may send a signal to the network device 02, and the network device 02 processes or stores the received signal. Alternatively, the network device 02 may send a signal to the first access device 03. In this way, signal exchange between the network device 02 and the first access device 03 is implemented.

Still as shown in FIG. 1, the communication system 01 may further include a plurality of second access devices 04 connected to the network device 02. Same as the first access device 03, the second access device 04 can also perform signal exchange with the network device 02. For example, the network device 02 may receive a signal sent by the first access device 03, perform processing and distribution on the signal, and then send the processed signal to different second access devices 04. Alternatively, the network device 02 may receive a signal sent by the second access device 04, and send the signal to the first access device 03.

In the foregoing embodiment, as shown in FIG. 1, an example in which the communication system 01 includes one network device 02, one first access device 03, and two second access devices 04 is used. In another embodiment of this application, quantities of network devices 02, first access devices 03, and second access devices 04 may each be other quantities.

In addition, the network device 02 may be optical access central office equipment, a switch, a data center, a server, or the like. For ease of description, the following uses an example in which the network device 02 is optical access central office equipment for description.

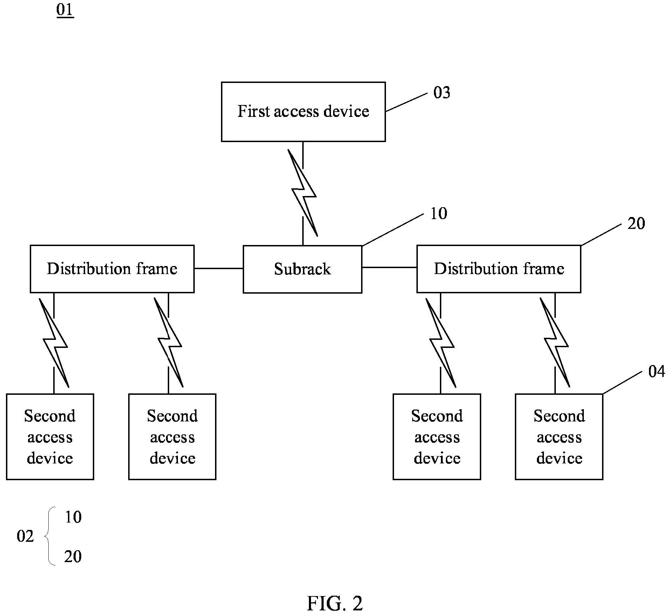

As shown in FIG. 2, the network device 02 in the communication system 01 is optical access central office equipment. In this case, in some embodiments of this application, the first access device 03 may be a central office or a base station, and the second access device 04 may be an optical network terminal (Optical network terminal, ONT) or an optical network unit (Optical Network Unit, ONU). The optical access central office equipment includes a subrack 10 and a plurality of distribution frames 20. The subrack 10 is connected to the first access device 03, and performs optical signal exchange. In addition, the subrack 10 is connected to the distribution frame 20, and performs optical signal exchange. Therefore, after the first access device 03 sends an optical signal to the subrack 10, the optical signal is distributed to different distribution frames 20 through the subrack 10, and then distributed to different second access devices 04 through different distribution frames 20. Alternatively, the second access device 04 sends an optical signal to the subrack 10 through the distribution frame 20, and the subrack 10 processes the optical signal and then sends a processed optical signal to the first access device 03. In this way, transmission of the optical signal is completed.

In the foregoing embodiment, as shown in FIG. 2, an example in which the communication system 01 includes one piece of optical access central office equipment, one first access device 03, and two second access devices 04, and the optical access central office equipment includes one subrack 10 and two distribution frames 20 is used. In another embodiment of this application, quantities of the optical access central office equipment, first access devices 03, and second access devices 04 may each be other quantities. A quantity of subracks 10 and a quantity of distribution frames 20 may also be other quantities.

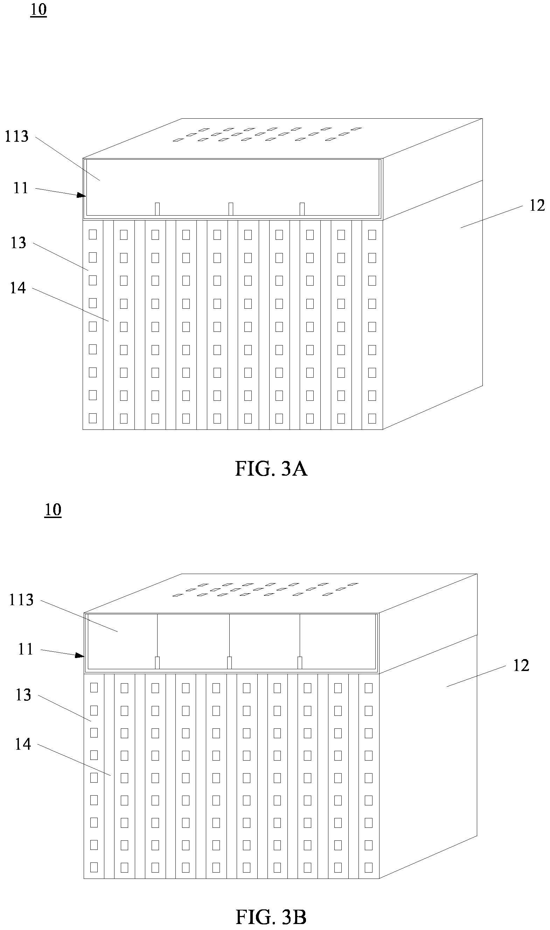

Based on this, in some embodiments of this application, the subrack 10 shown in FIG. 3A may include a heat dissipation architecture 11, a frame 12, and a plurality of boards 13. Both the heat dissipation architecture 11 and the board 13 may be disposed in the frame 12. The frame 12 can limit and protect the heat dissipation architecture 11 and the board 13. The plurality of boards 13 are all located on a same side of the heat dissipation architecture 11, and a heat dissipation gap 14 exists between adjacent boards 13. When the board 13 operates, heat is generated on a periphery of the board 13, and is dissipated into the heat dissipation gap 14. In this case, through air intake from or air exhaust to the heat dissipation gap 14, the heat dissipation architecture 11 enables air in the heat dissipation gap 14 to flow, thereby taking away heat of the heat dissipation gap 14, and thus reducing a temperature around the board 13. Finally, heat dissipation for the subrack 10 is completed.

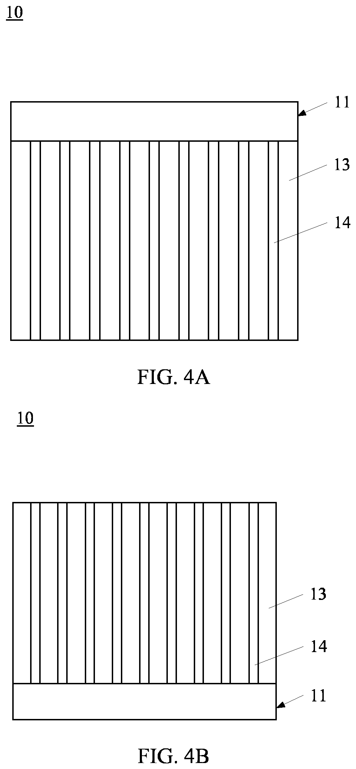

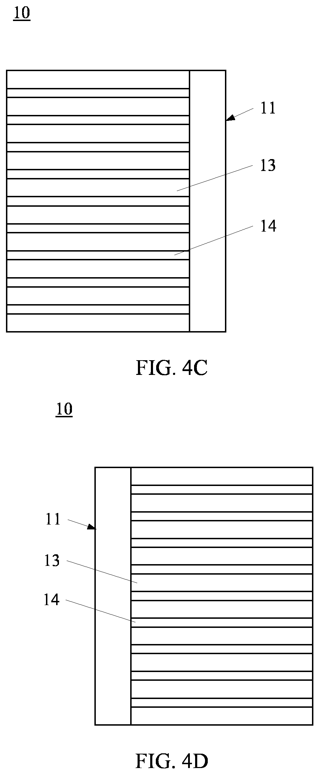

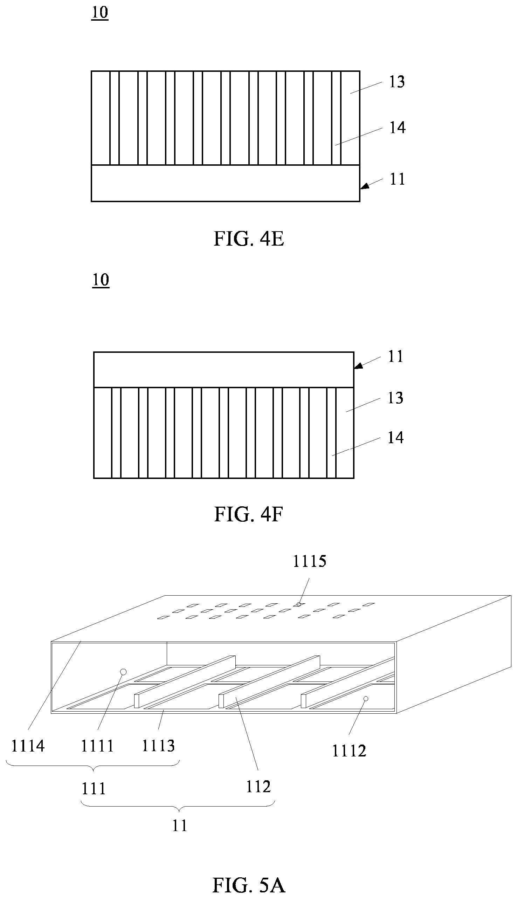

For example, the heat dissipation architecture 11 may be disposed above the board 13 as shown in FIG. 4A. Alternatively, the heat dissipation architecture 11 may be disposed below the board 13 as shown in FIG. 4B. Alternatively, the heat dissipation architecture 11 may be disposed on a right side of the board 13 as shown in FIG. 4C. Alternatively, the heat dissipation architecture 11 may be disposed on a left side of the board 13 as shown in FIG. 4D. Alternatively, the heat dissipation architecture 11 may be disposed on a front side of the board 13 as shown in FIG. 4E. Alternatively, the heat dissipation architecture 11 may be disposed on a rear side of the board 13 as shown in FIG. 4F.

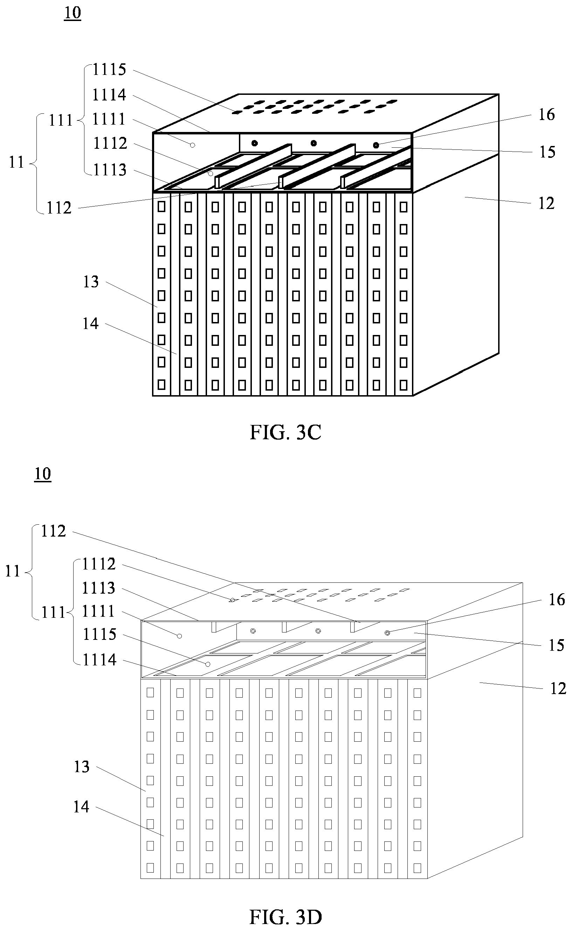

Further, as shown in FIG. 3C or FIG. 3D, the subrack 10 may further include a back plate 15 and at least one connector 16. A cable group (not shown in the figure) is disposed on the back plate 15, and each board 13 is connected to the cable group. Signals are exchanged and transmitted between different boards 13 through the cable group. The connector 16 is disposed on the back plate 15, one end of the connector 16 is electrically connected to the cable group, and the other end is electrically connected to the heat dissipation architecture 11. A signal is sent to the connector 16 through the cable group, and then the connector 16 sends the signal to the heat dissipation architecture 11, to adjust an operating power of the heat dissipation architecture 11. In addition, the cable group is further electrically connected to an external power supply, and the external power supply supplies power to the board 13 and the heat dissipation architecture 11 through the cable group. In this way, it is ensured that the board 13 and the heat dissipation architecture 11 can operate normally.

Based on this, in some embodiments of this application, the heat dissipation architecture 11 may include a heat dissipation frame body 111, as shown in FIG. 5A. The heat dissipation frame body 111 has a heat dissipation cavity 1111. The heat dissipation frame body 111 is provided with a first air vent 1112 that communicates with the heat dissipation cavity 1111. The first air vent 1112 communicates with a heat dissipation gap 14 (as shown in FIG. 3A), and the first air vent 1112 further communicates with the heat dissipation cavity 1111. Therefore, heat can be exchanged between the first air vent 1112, the heat dissipation gap 14, and the heat dissipation cavity 1111, to complete heat dissipation for the subrack 10.

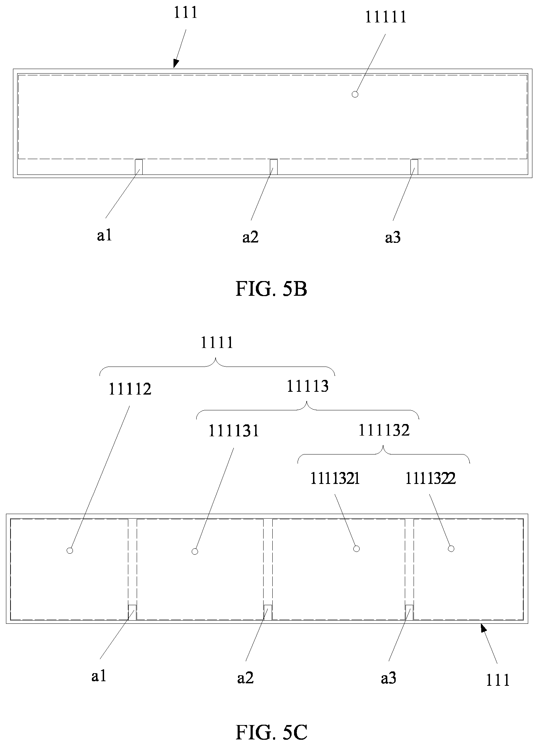

Still as shown in FIG. 5A, the heat dissipation frame body 111 may include a first cavity wall 1113 and a second cavity wall 1114 that are disposed opposite to each other. The heat dissipation architecture 11 may include at least one limiting member 112 disposed in the heat dissipation cavity 1111, and the limiting member 112 is disposed on the first cavity wall 1113. As shown in FIG. 5B, a first accommodating cavity 11111 is formed between the second cavity wall 1114 and a surface of a side of the limiting member 112 (as shown in FIG. 5A) facing away from the first cavity wall 1113. Because the limiting member 112 is located in the heat dissipation cavity 1111, the first accommodating cavity 11111 is part of the heat dissipation cavity 1111. In other words, the first accommodating cavity 11111 also communicates with the first air vent 1112 (as shown in FIG. 5A), so that heat can be exchanged between the first air vent 1112, the heat dissipation gap 14 (as shown in FIG. 3A), and the first accommodating cavity 11111. In addition, as shown in FIG. 5C, the limiting member 112 divides the heat dissipation cavity 1111 into a second accommodating cavity 11112 and a third accommodating cavity 11113 along an extension direction of the limiting member 112. Similarly, the second accommodating cavity 11112 and the third accommodating cavity 11113 are also part of the heat dissipation cavity 1111. Therefore, both the first accommodating cavity 11111 and the second accommodating cavity 11112 can exchange heat with the first air vent 1112 and the heat dissipation gap 14.

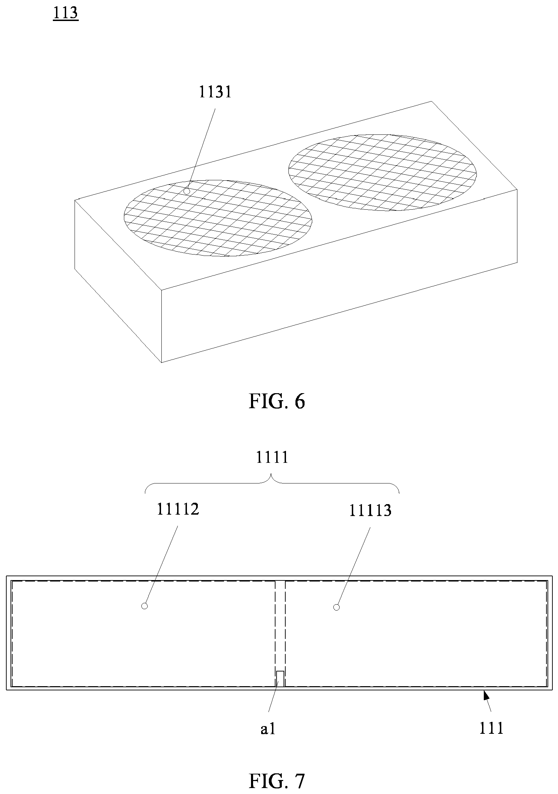

On this basis, as shown in FIG. 3A or FIG. 3B, the heat dissipation architecture 11 may include at least one fan tray 113, and the fan tray 113 may be disposed in the heat dissipation cavity 1111 (as shown in FIG. 5A). The fan tray 113 may have an air port 1131 as shown in FIG. 6, and the air port 1131 may face the first air vent 1112 (as shown in FIG. 5A). For example, the air port 1131 of the fan tray 113 may be an air inlet. When operating, through air intake from the first air vent 1112 via the air port 1131, the fan tray 113 enables air between the first air vent 1112 and the heat dissipation gap 14 to flow, thereby cooling the heat dissipation gap 14. Alternatively, for example, the air port 1131 of the fan tray 113 may be an air outlet. When operating, through air exhaust to the first air vent 1112 via the air port 1131, the fan tray 113 enables air between the first air vent 1112 and the heat dissipation gap 14 to flow, thereby cooling the heat dissipation gap 14. In this way, a heat dissipation function is implemented.

In addition, still as shown in FIG. 3A or FIG. 3B, the fan tray 113 may be disposed in the first accommodating cavity 11111, the second accommodating cavity 11112, or the third accommodating cavity 11113. Alternatively, a part of the fan tray 113 may be disposed in the second accommodating cavity 11112, and the other part may be disposed in the third accommodating cavity 11113. In this way, still as shown in FIG. 3A, at an early evolution stage of the subrack 10, before network upgrades, heat dissipation requirements of the subrack 10 are low, and a time during which the heat dissipation architecture 11 can be allowed to stop heat dissipation is long. In this case, to reduce costs, one fan tray 113 may be disposed in the first accommodating cavity 11111. In addition, because the first accommodating cavity 11111 is located between the limiting member 112 and the second cavity wall 1114, that is, the limiting member 112 does not prevent the fan tray 113 from being disposed in the first accommodating cavity 11111, a size of the fan tray 113 can be large, so that heat dissipation requirements are met in this case. When the fan tray 113 fails or needs to be maintained, the fan tray 113 can also be taken out for repair or maintenance.

However, with development of network devices, subracks have continuously evolved. After networks are gradually upgraded, traffic volumes of the subracks are large, heat dissipation requirements are high, and times during which heat dissipation architectures are allowed to stop heat dissipation are short. In this case, if only one fan tray is disposed, when the fan tray is repaired or maintained, a time during which the heat dissipation architecture stops heat dissipation cannot meet heat dissipation requirements of the subrack. In this case, as shown in FIG. 3B, in the heat dissipation architecture 11, at least two independent fan trays 113 may be disposed in the first accommodating cavity 11111 (as shown in FIG. 5C) and the second accommodating cavity 11112 (as shown in FIG. 5C). When one of the fan trays 113 needs to be repaired or maintained, another fan tray 113 continues to operate, so that it is ensured that the heat dissipation architecture 11 does not completely lose a heat dissipation function, to meet high heat dissipation requirements. In addition, the subrack 10 may further adjust power consumption of different fan trays 113 separately with reference to heat dissipation requirements of areas in which different boards are located, to meet heat dissipation requirements and minimize overall power consumption.

In the related technology, the fan tray of the heat dissipation architecture is an integrated fan tray, all heat dissipation fans are integrated together by using an integrated structure, and costs are low. However, when the integrated fan tray fails or needs to be maintained, the integrated fan tray needs to be stopped from operating. To ensure that the subrack operates normally, an allowed repair or maintenance time for the integrated fan tray is short. As a result, repair is inconvenient and heat dissipation requirements of the subrack in a later evolution phase cannot be met. In addition, this type of subrack cannot implement area-based power consumption adjustment to match heat dissipation requirements of different areas. Alternatively, in another related technology, the heat dissipation architecture includes a plurality of cavities that are separated from each other, and one fan tray is disposed in each cavity. However, in this manner, a plurality of fan trays are used, and costs are high. In addition, the plurality of cavities are separated from each other. Consequently, a fan tray having a size greater than that of one cavity cannot be installed in the heat dissipation architecture. However, as shown in FIG. 5A, the limiting member 112 of the heat dissipation architecture 11 provided in this application does not prevent the fan tray 113 (as shown in FIG. 3A) from being disposed in the first accommodating cavity 11111, so that a size of the fan tray 113 can be large. In addition, the heat dissipation architecture 11 provided in this application can adapt to an evolution process of the subrack 10. When the traffic volume of the subrack 10 is small and heat dissipation requirements are low, a fan tray 113 with a large size is disposed, to ensure a heat dissipation capability while reducing costs. When the traffic volume of the subrack 10 is large and heat dissipation requirements are high, a plurality of fan trays 113 are disposed, to ensure that the heat dissipation architecture 11 does not completely lose a heat dissipation function during repair or maintenance of the fan tray 113. In this way, subrack evolution is matched, heat dissipation requirements can be met before and after network upgrades, and costs are reduced.

Alternatively, for example, as shown in FIG. 3C, the first cavity wall 1113 faces the board 13. The first cavity wall 1113 is provided with the first air vent 1112. The first air vent 1112 may be enclosed by a framework of the first cavity wall 1113. The second cavity wall 1114 is provided with a second air vent 1115, and the second air vent 1115 communicates with the external atmosphere. The first air vent 1112 faces the heat dissipation gap 14. The fan tray 113 (as shown in FIG. 3A) may include the air inlet and the air outlet. The air inlet of the fan tray 113 faces the first air vent 1112, and the air outlet of the fan tray 113 faces the second air vent 1115. When the fan tray 113 operates, airflow that flows from the air outlet to the second air vent 1115 is generated, so that air is driven to enter the air inlet, and airflow that flows from the first air vent 1112 to the air inlet is generated. In this way, air in the heat dissipation gap 14 is driven to flow to the first air vent 1112, and finally airflow that flows from the heat dissipation gap 14 to the first air vent 1112, the air inlet, the air outlet, and the second air vent 1115 sequentially before being discharged into the external atmosphere eventually is generated, to complete heat dissipation for the subrack 10.

Alternatively, as shown in FIG. 3D, the second cavity wall 1114 faces the board 13. The first air vent 1112 communicates with the external atmosphere. The second air vent 1115 faces the heat dissipation gap 14. The second air vent 1115 may be enclosed by a framework of the second cavity wall 1114. The fan tray 113 (as shown in FIG. 3A or FIG. 3B) may include an air inlet and an air outlet. The air inlet of the fan tray 113 faces the second air vent 1115, and the air outlet of the fan tray 113 faces the first air vent 1112. When the fan tray 113 operates, airflow that flows from the air outlet to the first air vent 1112 is generated, so that air is driven to enter the air inlet, and airflow that flows from the second air vent 1115 to the air inlet is generated. In this way, air in the heat dissipation gap 14 is driven to flow to the second air vent 1115, and finally airflow that flows from the heat dissipation gap 14 to the second air vent 1115, the air inlet, the air outlet, and the first air vent 1112 sequentially before being discharged into the external atmosphere eventually is generated, to complete heat dissipation for the subrack 10.

In addition, as shown in FIG. 3C or FIG. 3D, the fan tray 113 (as shown in FIG. 3A or FIG. 3B) is electrically connected to the connector 16. When the fan tray 113 is installed into the heat dissipation cavity 1111 along the extension direction of the limiting member 112, the fan tray 113 moves toward the connector 16, until one end of the connector 16 snaps into a connection end of the fan tray 113 and is electrically connected to the fan tray 113, so that it is ensured that power is supplied to the fan tray 113.

For example, at least one fan (not shown in the figure) is disposed in the fan tray 113, and the fan is electrically connected to the connector 16. Power is supplied to the fan, so that the fan operates to dissipate heat.

The following embodiment is described by using an example in which at least two fan trays are disposed in the heat dissipation cavity.

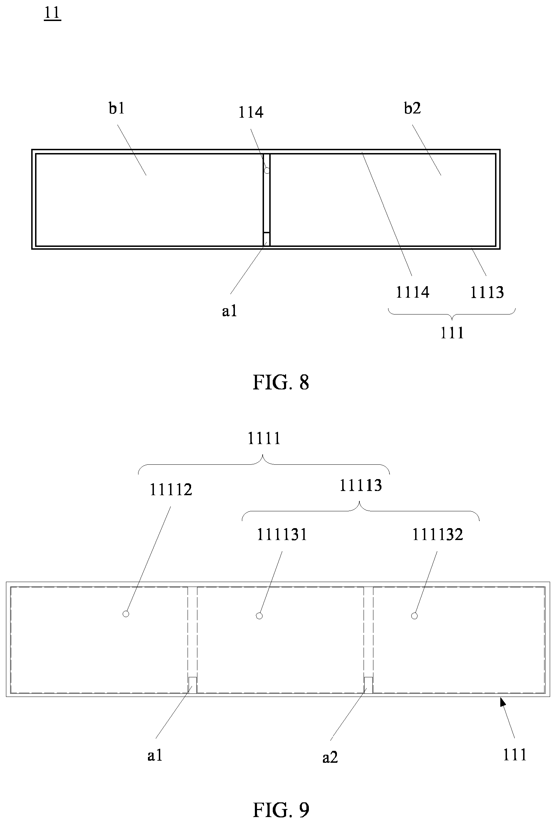

In some embodiments of this application, as shown in FIG. 7, the at least one limiting member 112 may include a first limiting member a1. The first limiting member a1 divides the heat dissipation cavity 1111 into the second accommodating cavity 11112 and the third accommodating cavity 11113 along an extension direction of the first limiting member a1. As shown in FIG. 8, the at least one fan tray 113 (as shown in FIG. 3B) may include a first fan tray b1 and a second fan tray b2. A first gap 114 exists between the first fan tray b1 and the second fan tray b2. The first gap 114 can accommodate the first limiting member a1, to ensure that the first limiting member a1 is located between the first fan tray b1 and the second fan tray b2. The first fan tray b1 is disposed in the second accommodating cavity 11112, and a surface of a side of the first fan tray b1 facing the third accommodating cavity 11113 is slidably engaged with the first limiting member a1. In this case, in a direction in which the first fan tray b1 faces the third accommodating cavity 11113, the first limiting member a1 can limit the first fan tray b1, to ensure that the first fan tray b1 slides along the first limiting member a1, thereby ensuring that the first fan tray b1 is installed at an expected position to be aligned with and electrically connected to a corresponding connector 16 (as shown in FIG. 3C). In addition, the second fan tray b2 is disposed in the third accommodating cavity 11113, and a surface of a side of the second fan tray b2 facing the second accommodating cavity 11112 is slidably engaged with the first limiting member a1. In this case, in a direction in which the second fan tray b2 faces the second accommodating cavity 11112, the first limiting member a1 can also limit the second fan tray b2, to ensure that the second fan tray b2 also slides along the first limiting member a1, thereby ensuring that the second fan tray b2 is installed at an expected position to be aligned with and electrically connected to a corresponding connector 16.

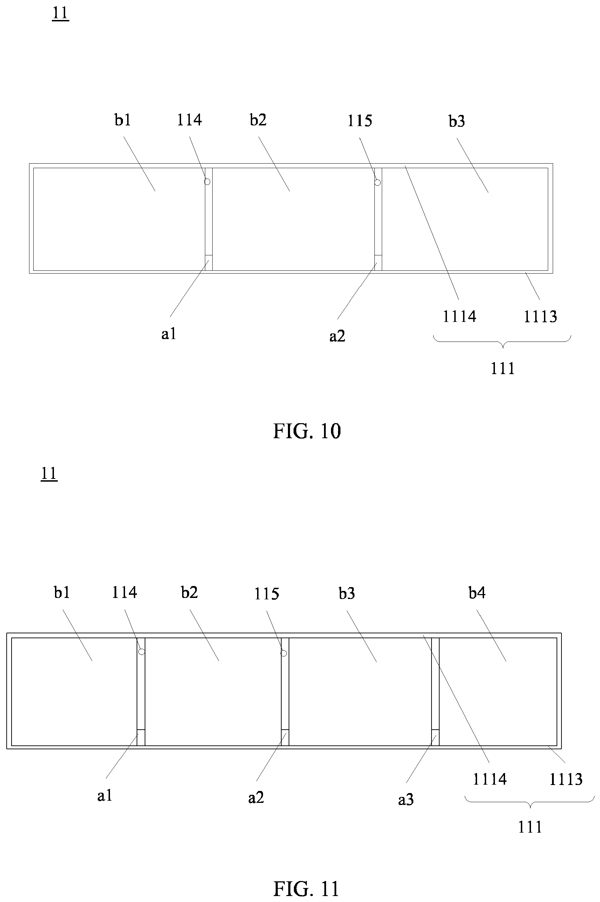

In some other embodiments of this application, as shown in FIG. 9, the at least one limiting member 112 (as shown in FIG. 5A) may further include a second limiting member a2. The second limiting member a2 is located in the third accommodating cavity 11113, and the second limiting member a2 divides the third accommodating cavity 11113 into a fourth accommodating cavity 111131 and a fifth accommodating cavity 111132 along an extension direction of the second limiting member a2. As shown in FIG. 10, the second fan tray b2 is located in the fourth accommodating cavity 111131, and a surface of a side of the second fan tray b2 facing the fifth accommodating cavity 111132 is slidably engaged with the second limiting member a2. In this case, after the second fan tray b2 is disposed in the fourth accommodating cavity 111131, the second limiting member a2 can also limit and guide the second fan tray b2. The first limiting member a1 and the second limiting member a2 respectively limit and guide two sides of the second fan tray b2, to further ensure that the second fan tray b2 can be aligned with and electrically connected to the corresponding connector 16 (as shown in FIG. 3C) during installation. In addition, the at least one fan tray 113 (as shown in FIG. 3B) further includes a third fan tray b3. A quantity of fan trays 113 is further increased. When one of the fan trays 113 is repaired or maintained, a quantity of remaining fan trays 113 that continue to operate is large, so that it is ensured that heat dissipation of the other fan trays 113 can meet requirements of the subrack 10 when one fan tray 113 is repaired or maintained. A second gap 115 exists between the second fan tray b2 and the third fan tray b3, and the second gap 115 can accommodate the second limiting member a2, to ensure that the second limiting member a2 is located between the second fan tray b2 and the third fan tray b3. The third fan tray b3 is located in the fifth accommodating cavity 111132, and a surface of a side of the third fan tray b3 facing the fourth accommodating cavity 111131 is slidably engaged with the second limiting member a2. In this case, the second limiting member a2 can limit and guide the third fan tray b3, to ensure that the third fan tray b3 slides along the second limiting member a2, thereby ensuring that the third fan tray b3 can be aligned with and electrically connected to a corresponding connector 16.

In still some embodiments of this application, as shown in FIG. 5C, the at least one limiting member 112 may further include a third limiting member a3. The third limiting member a3 is located in the fifth accommodating cavity 111132, and the third limiting member a3 divides the fifth accommodating cavity 111132 into a sixth accommodating cavity 111321 and a seventh accommodating cavity 111322 along an extension direction of the third limiting member a3. As shown in FIG. 11, the third fan tray b3 is located in the sixth accommodating cavity 111321, and a surface of a side of the third fan tray b3 facing the sixth accommodating cavity 111321 is slidably engaged with the third limiting member a3. The third limiting member a3 is used to further limit the third fan tray b3, to further ensure that the third fan tray b3 can be aligned with and electrically connected to the corresponding connector 16 (as shown in FIG. 3C). In addition, the at least one fan tray 113 further includes a fourth fan tray b4. A total quantity of fan trays 113 is further increased, to ensure heat dissipation effect of the heat dissipation architecture 11. The fourth fan tray b4 is located in the seventh accommodating cavity 111322, and a surface of a side of the fourth fan tray b4 facing the sixth accommodating cavity 111321 is slidably engaged with the third limiting member a3. In this case, the third limiting member a3 can limit and guide the fourth fan tray b4, to ensure that the fourth fan tray b4 slides along the third limiting member a3, thereby ensuring that the fourth fan tray b4 can be aligned with and electrically connected to a corresponding connector 16.

Certainly, embodiments shown in FIG. 8, FIG. 10, and FIG. 11 are described by using examples in which a quantity of limiting members is 1, 2, and 3, and a quantity of fan trays is 2, 3, and 4, respectively. In other embodiments of this application, the quantity of limiting members and the quantity of fan trays may alternatively be other quantities. For example, the quantity of limiting members is 4, 5, or 6, and the quantity of fan trays may be 5, 6, or 7.

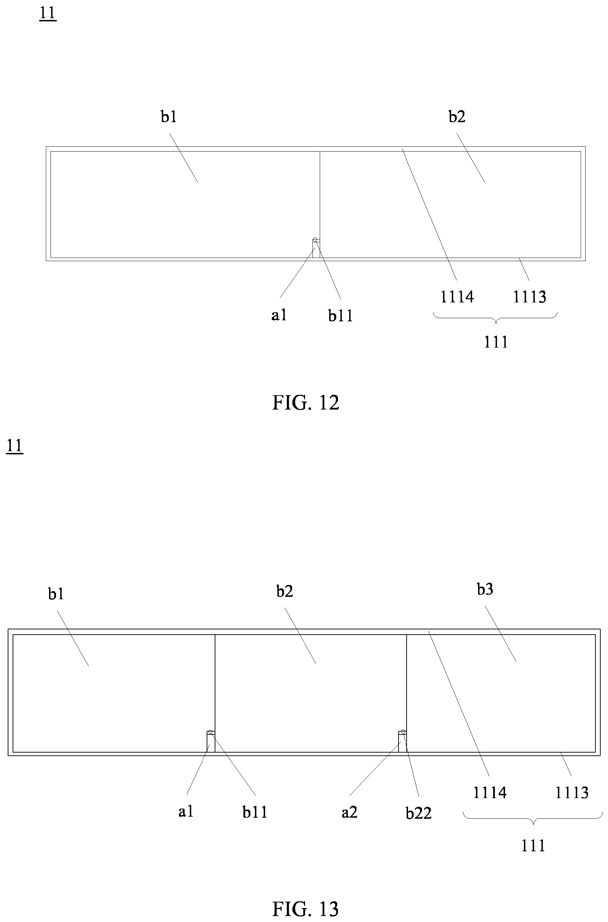

In some embodiments of this application, on a basis that the first limiting member a1 divides the heat dissipation cavity 1111 into the second accommodating cavity 11112 and the third accommodating cavity 11113 as shown in FIG. 7, as shown in FIG. 12, the at least one fan tray 113 may include the first fan tray b1 and the second fan tray b2. The second fan tray b2 is disposed in the third accommodating cavity 11113. The surface of the side of the second fan tray b2 facing the second accommodating cavity 11112 is slidably engaged with the limiting member 112. The first limiting member a1 can limit and guide the second fan tray b2, to ensure that the second fan tray b1 can be aligned with and electrically connected to the corresponding connector 16 (as shown in FIG. 3C). The first fan tray b1 is disposed in the second accommodating cavity 11112. A side of the first fan tray b1 facing the first cavity wall 1113 is provided with a first sliding groove b11. The first limiting member a1 is located in the first sliding groove b11, and is engaged with the first sliding groove b11. In this case, the first limiting member a1 can still limit and guide the first fan tray b1, to ensure that the first fan tray b1 slides along the first limiting member a1, thereby ensuring that the first fan tray b1 can be aligned with and electrically connected to the corresponding connector 16. In addition, the first sliding groove b11 can accommodate the first limiting member a1, so that there is no need to reserve a gap, between the first fan tray b1 and the second fan tray b2, that is large enough to accommodate the first limiting member a1. In other words, a gap between a surface of the first fan tray b1 facing the second fan tray b2 and a surface of the second fan tray b2 facing the first fan tray b1 may be small or there may even be no gap. In this way, space occupied by the first fan tray b1 and the second fan tray b2 in the heat dissipation cavity 1111 is large, thereby improving space utilization of the heat dissipation cavity 1111.

Further, still as shown in FIG. 12, the surface of the first fan tray b1 facing the second fan tray b2 abuts against the surface of the second fan tray b2 facing the first fan tray b1. In this case, apart from the first sliding groove b11 used to accommodate the first limiting member a1, there is no other gap between the first fan tray b1 and the second fan tray b2, so that space occupied by the first fan tray b1 and the second fan tray b2 in the heat dissipation cavity 1111 is further increased, thereby further improving space utilization of the heat dissipation cavity 1111.

In some other embodiments of this application, on a basis that the second limiting member a2 divides the third accommodating cavity 11113 into the fourth accommodating cavity 111131 and the fifth accommodating cavity 111132 as shown in FIG. 9, as shown in FIG. 13, the at least one fan tray 113 may further include the third fan tray b3. In this case, the quantity of fan trays is larger. This ensures that when one fan tray is repaired or maintained, heat dissipation of the other fan trays can meet requirements of the subrack. The second fan tray b2 is disposed in the fourth accommodating cavity 111131, and the third fan tray b3 is disposed in the fifth accommodating cavity 111132. A side of the second fan tray b2 facing the first cavity wall 1113 is provided with a sixth sliding groove b22. The second limiting member a2 is located in the sixth sliding groove b22, and is engaged with the sixth sliding groove b22. This ensures that the second fan tray b2 can be aligned with and electrically connected to the corresponding connector 16 (as shown in FIG. 3C). In addition, this embodiment is the same as the foregoing embodiment in that space utilization of the heat dissipation cavity 1111 can be improved. The third fan tray b3 is located in the fifth accommodating cavity 111132, and the surface of the side of the third fan tray b3 facing the fourth accommodating cavity 111131 is slidably engaged with the second limiting member a2. This ensures that the third fan tray b3 can be aligned with and electrically connected to the corresponding connector 16.

Certainly, embodiments shown in FIG. 12 and FIG. 13 are described by using examples in which the quantity of limiting members is 1 and 2, and the quantity of fan trays is 2 and 3, respectively. In other embodiments of this application, the quantity of limiting members and the quantity of fan trays may alternatively be other quantities. For example, the quantity of limiting members is 3, 4, 5, or 6, and the quantity of fan trays may be 4, 5, 6, or 7.

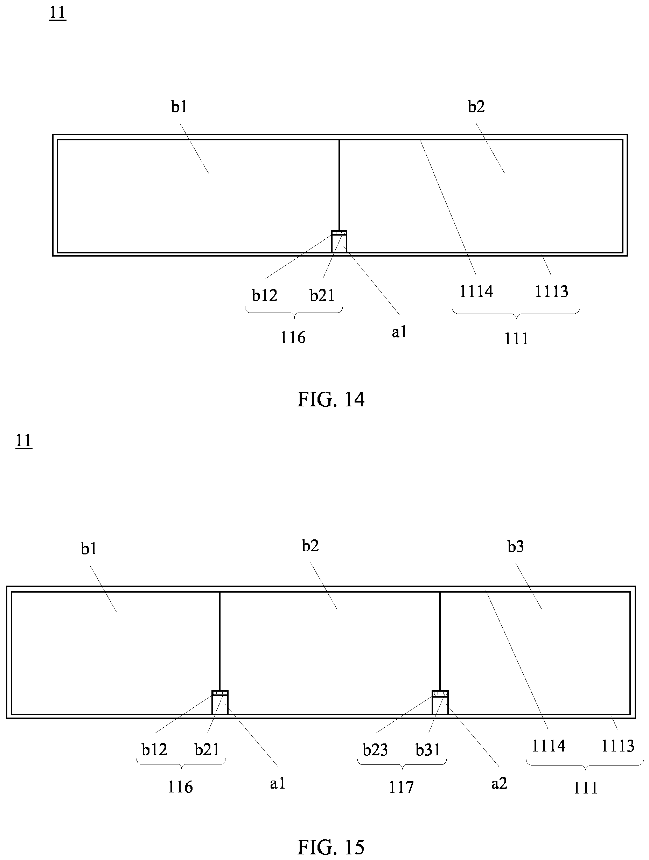

In some embodiments of this application, on a basis that the first limiting member a1 divides the heat dissipation cavity 1111 into the second accommodating cavity 11112 and the third accommodating cavity 11113 as shown in FIG. 7, as shown in FIG. 14, the first fan tray b1 is disposed in the second accommodating cavity 11112, and the side of the first fan tray b1 facing the first cavity wall 1113 is provided with a first recess portion b12. The second fan tray b2 is disposed in the third accommodating cavity 11113, and the side of the second fan tray b2 facing the first cavity wall 1113 is provided with a second recess portion b21. The first recess portion b12 and the second recess portion b21 collectively form a second sliding groove 116. The first limiting member a1 is located in the second sliding groove 116, and is engaged with the second sliding groove 116. The first limiting member a1 is engaged with the second sliding groove 116, to limit and guide sliding of the first fan tray b1 and the second fan tray b2, to ensure that both the first fan tray b1 and the second fan tray b2 can be aligned with and electrically connected to corresponding connectors 16 (as shown in FIG. 3C). In addition, this embodiment is the same as the embodiment shown in FIG. 10 in that the second sliding groove 116 can accommodate the first limiting member a1, and a gap between the surface of the first fan tray b1 facing the second fan tray b2 and the surface of the second fan tray b2 facing the first fan tray b1 may be small or there may even be no gap. In this way, space utilization of the heat dissipation cavity 1111 is improved.

In some other embodiments of this application, on a basis that the second limiting member a2 divides the third accommodating cavity 11113 into the fourth accommodating cavity 111131 and the fifth accommodating cavity 111132 as shown in FIG. 9, as shown in FIG. 15, the at least one fan tray 113 may further include the second fan tray b2 and the third fan tray b3. In this case, the quantity of fan trays 113 is larger. This ensures that when one fan tray 113 is repaired or maintained, heat dissipation of the other fan trays 113 can meet requirements of the subrack 10. The second fan tray b2 is disposed in the fourth accommodating cavity 111131, and the side of the second fan tray b2 facing the first cavity wall 1113 is provided with a third recess portion b23. The third fan tray b3 is located in the fifth accommodating cavity 111132, and a side of the third fan tray b3 facing the first cavity wall 1113 is provided with a fourth recess portion b31. The third recess portion b23 and the fourth recess portion b31 collectively form a seventh sliding groove 117. The second limiting member a2 is located in and engaged with the seventh sliding groove 117. In this case, this embodiment is similar to the embodiment shown in FIG. 14 in that the second limiting member a2 is engaged with the seventh sliding groove 117, to limit and guide sliding of the second fan tray b2 and the third fan tray b3, to ensure that both the second fan tray b2 and the third fan tray b3 can be aligned with and electrically connected to the corresponding connectors 16 (as shown in FIG. 3C).

Certainly, embodiments shown in FIG. 14 and FIG. 15 are described by using examples in which the quantity of limiting members is 1 and 2, and the quantity of fan trays is 2 and 3, respectively. In other embodiments of this application, the quantity of limiting members and the quantity of fan trays may alternatively be other quantities. For example, the quantity of limiting members is 3, 4, 5, or 6, and the quantity of fan trays may be 4, 5, 6, or 7.

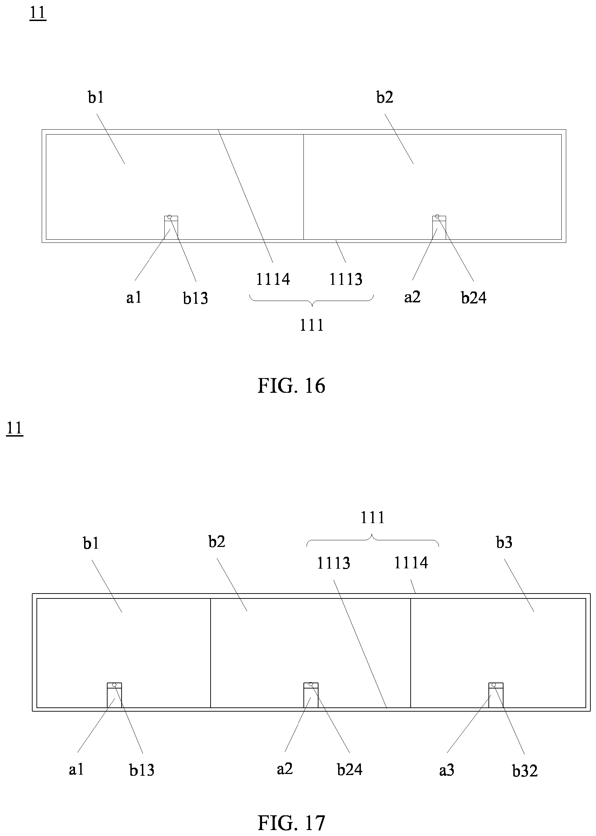

In some embodiments of this application, on a basis that the first limiting member a1 divides the heat dissipation cavity 1111 into the second accommodating cavity 11112 and the third accommodating cavity 11113, and the second limiting member a2 divides the third accommodating cavity 11113 into the fourth accommodating cavity 111131 and the fifth accommodating cavity 111132 as shown in FIG. 9, as shown in FIG. 16, the at least one fan tray 113 may include the first fan tray b1 and the second fan tray b2. The first fan tray b1 is disposed in the second accommodating cavity 11112 and the fourth accommodating cavity 111131, and is located between the first limiting member a1 and the second cavity wall 1114. The first fan tray b1 is slidably engaged with a surface of the first limiting member a1 facing the second cavity wall 1114. In this case, the first fan tray b1 can slide on the surface of the first limiting member a1 facing the second cavity wall 1114, to implement installation and removal of the first fan tray b1. In addition, the second fan tray b2 is disposed in the fourth accommodating cavity 111131 and the fifth accommodating cavity 111132, and is located between the second limiting member a2 and the second cavity wall 1114. The second fan tray b2 is slidably engaged with a surface of the second limiting member a2 facing the second cavity wall 1114. In this case, the second fan tray b2 can slide on the surface of the second limiting member a2 facing the second cavity wall 1114, to implement installation and removal of the second fan tray b2. In this way, two fan trays 113 are installed in the heat dissipation cavity 1111.

Still as shown in FIG. 16, the side of the first fan tray b1 facing the first cavity wall 1113 is provided with a third sliding groove b13. The first limiting member a1 is located in and engaged with the third sliding groove b13. In this case, in a direction perpendicular to the extension direction of the first limiting member a1 and parallel to the first cavity wall 1113, the first limiting member a1 can limit the first fan tray b1, so that the first limiting member a1 can guide sliding of the first fan tray b1. In addition, the side of the second fan tray b2 facing the first cavity wall 1113 is provided with a fourth sliding groove b24. The second limiting member a2 is located in and engaged with the fourth sliding groove b24. In this case, the second limiting member a2 can also limit the second fan tray b2, so that the second limiting member a2 can guide sliding of the second fan tray b2. This ensures that both the first fan tray b1 and the second fan tray b2 can be aligned with and electrically connected to the corresponding connectors 16 (as shown in FIG. 3C).

In some embodiments of this application, on a basis that the third limiting member a3 divides the fifth accommodating cavity 111132 into the sixth accommodating cavity 111321 and the seventh accommodating cavity 111322 as shown in FIG. 5C, as shown in FIG. 17, the at least one fan tray 113 may further include the third fan tray b3. The third fan tray b3 is disposed in the sixth accommodating cavity 111321 and the seventh accommodating cavity 111322. In addition, the side of the third fan tray b3 facing the first cavity wall 1113 is provided with an eighth sliding groove b32, and the third limiting member a3 is located in the eighth sliding groove b32. This embodiment is the same as the embodiment shown in FIG. 16 in that the third limiting member a3 can also limit the third fan tray b3, so that the third limiting member a3 can guide sliding of the third fan tray b3. This ensures that the third fan tray b3 can be aligned with and electrically connected to the corresponding connector 16 (as shown in FIG. 3C).

Certainly, embodiments shown in FIG. 16 and FIG. 17 are described by using examples in which the quantity of limiting members is 2 and 3, and the quantity of fan trays is 2 and 3, respectively. In other embodiments of this application, the quantity of limiting members and the quantity of fan trays may alternatively be other quantities. For example, the quantity of limiting members is 4, 5, 6, or 7, and the quantity of fan trays may also be 4, 5, 6, or 7.

The following embodiment is described by using an example in which one fan tray is disposed in the heat dissipation cavity.

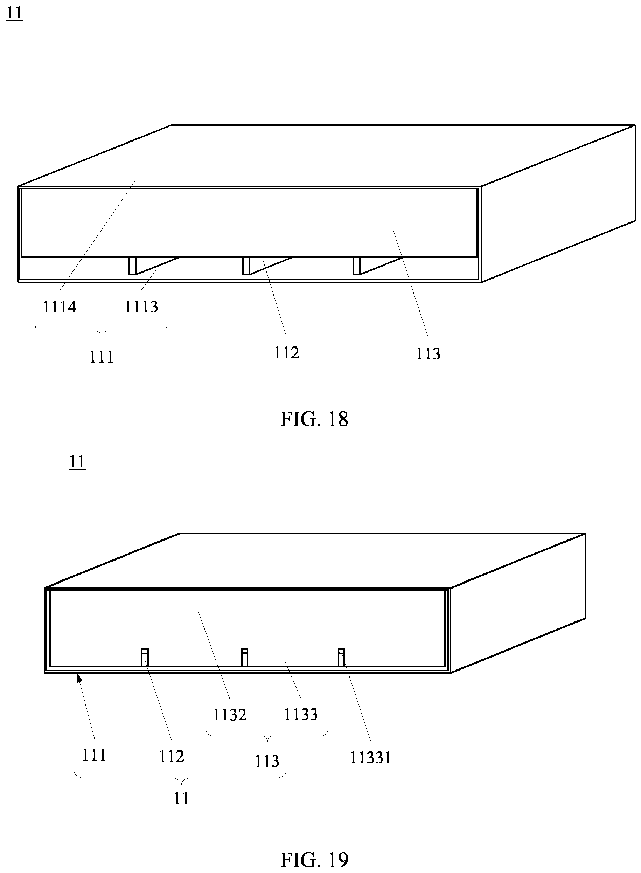

In some embodiments of this application, as shown in FIG. 18, the fan tray 113 may be disposed in the first accommodating cavity 11111 (as shown in FIG. 5B). At an early evolution stage of the subrack, before network upgrades, the traffic volume of the subrack is small, and only one fan tray 113 may be installed in the heat dissipation cavity 1111 (as shown in FIG. 5A), to meet low heat dissipation requirements before network upgrades while reducing costs.

In some other embodiments of this application, as shown in FIG. 19, the fan tray 113 may include a first part 1132 and a second part 1133. The first part 1132 is disposed in the first accommodating cavity 11111 (as shown in FIG. 5B). A side of the second part 1133 facing the first cavity wall 1113 is provided with a fifth sliding groove 11331, and the limiting member 112 is located in and engaged with the fifth sliding groove 11331. In this case, the second part 1133 of the fan tray 113 is located between the first cavity wall 1113 and the surface of the side of the limiting member 112 facing away from the first cavity wall 1113. This case is different from a case in which the entire fan tray 113 is disposed in the first accommodating cavity 11111 in that the fan tray 113 occupies large space in the heat dissipation cavity 1111 (as shown in FIG. 5A). This improves space utilization of the heat dissipation cavity 1111.

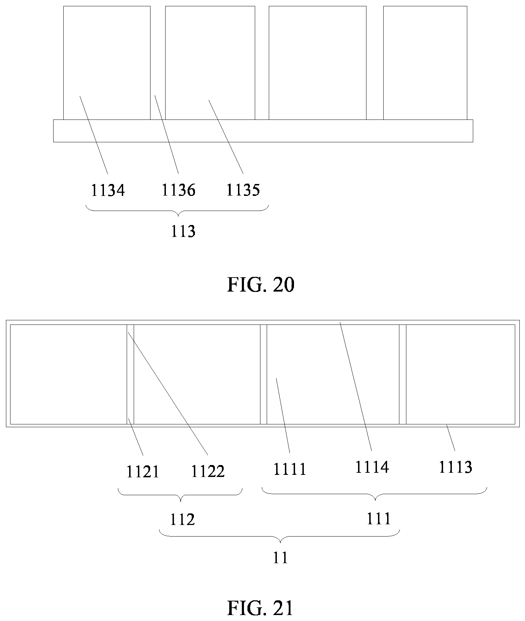

In still some embodiments of this application, as shown in FIG. 20, the fan tray 113 may include a first fan assembly 1134 and a second fan assembly 1135, and sides of the first fan assembly 1134 and the second fan assembly 1135 facing away from the heat dissipation cavity 1111 (as shown in FIG. 5A) are connected to each other. A third gap 1136 exists between the first fan assembly 1134 and the second fan assembly 1135. The limiting member 112 (as shown in FIG. 5A) is located in the third gap 1136. In this case, the limiting member 112 is located in the third gap 1136 between the first fan assembly 1134 and the second fan assembly 1135, and the limiting member 112 does not prevent the first fan assembly 1134 and the second fan assembly 1135 from being installed in the heat dissipation cavity 1111. In this way, it is ensured that the fan tray 113 can be installed in the heat dissipation cavity 1111 at the early evolution stage of the subrack.

Alternatively, in some embodiments of this application, the heat dissipation architecture 11 may further include the heat dissipation frame body 111 and the at least one limiting member 112, as shown in FIG. 21. The heat dissipation frame body 111 has the heat dissipation cavity 1111. The heat dissipation frame body 111 includes the first cavity wall 1113 and the second cavity wall 1114 that are disposed opposite to each other. The limiting member 112 is located in the heat dissipation cavity 1111, and a first end 1121 of the limiting member 112 is detachably connected to the first cavity wall 1113. At an early evolution stage of the subrack, heat dissipation requirements are low before network upgrades. In this case, after the limiting member 112 is detached from the first cavity wall 1113, a large fan tray 113 can be installed in the heat dissipation cavity 1111. As the subrack 10 evolves, after network upgrades, heat dissipation requirements are high. After the limiting member 112 is installed on the first cavity wall 1113, the limiting member 112 may divide the heat dissipation cavity 1111 into at least two independent cavities, and at least two independent fan trays 113 may be disposed in the at least two independent cavities respectively, to ensure that the fan trays 113 can be repaired or maintained one by one, and ensure that at least one fan tray 113 is in an operating state to meet the heat dissipation requirements. In this way, heat dissipation requirements can be met before and after network upgrades, and costs are reduced.

For example, still as shown in FIG. 21, a second end 1122 of the limiting member 112 may abut against the second cavity wall 1114. Alternatively, a gap may exist between the second end 1122 of the limiting member 112 and the second cavity wall 1114. Alternatively, the second end 1122 of the limiting member 112 is detachably connected to the second cavity wall 1114. This ensures that the limiting member 112 can be detached from the heat dissipation frame body 111.

In some other embodiments of this application, as shown in FIG. 21, the first end 1121 of the limiting member 112 is fixedly connected to the first cavity wall 1113, and the second end 1122 of the limiting member 112 is connected to the second cavity wall 1114. In this case, the limiting member 112 is fastened securely, to ensure stability of connection between the limiting member 112 and the heat dissipation frame body 111. On this basis, as shown in FIG. 20, the fan tray 113 may include the first fan assembly 1134 and the second fan assembly 1135, and the sides of the first fan assembly 1134 and the second fan assembly 1135 facing away from the heat dissipation cavity 1111 are connected to each other. The third gap 1136 exists between the first fan assembly 1134 and the second fan assembly 1135. The limiting member 112 is located in the third gap 1136, and the limiting member 112 does not prevent the first fan assembly 1134 and the second fan assembly 1135 from being installed in the heat dissipation cavity 1111. In this way, it can be ensured that the fan tray 113 can be installed in the heat dissipation cavity 1111 at an early evolution stage of the subrack 10, to meet low heat dissipation requirements before network upgrades. After network upgrades, the fan tray 113 may be replaced with two independent fan trays 113, and the two independent fan trays 113 are installed in the second accommodating cavity 11112 and the third accommodating cavity 11113 respectively, to ensure that the fan trays 113 can be repaired or maintained one by one, and ensure that at least one fan tray 113 is in an operating state to meet the heat dissipation requirements. In this way, heat dissipation requirements can be met before and after network upgrades, and costs are reduced.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A heat dissipation architecture, comprising:
a heat dissipation frame body, having a heat dissipation cavity, wherein the heat dissipation frame body comprises a first cavity wall and a second cavity wall that are disposed opposite to each other; and the heat dissipation frame body is provided with a first air vent that communicates with the heat dissipation cavity;
at least one limiting member, located in the heat dissipation cavity, wherein the limiting member is disposed on the first cavity wall; a first accommodating cavity is formed between the second cavity wall and a surface of a side of the limiting member facing away from the first cavity wall; and the limiting member divides the heat dissipation cavity into a second accommodating cavity and a third accommodating cavity along an extension direction of the limiting member; and
at least one fan tray, located in the heat dissipation cavity, wherein an air port of the fan tray faces the first air vent; and the fan tray is slidably engaged with the limiting member along the extension direction of the limiting member.

2. The heat dissipation architecture according to claim 1, wherein the at least one limiting member comprises:
a first limiting member, wherein the first limiting member divides the heat dissipation cavity into the second accommodating cavity and the third accommodating cavity along an extension direction of the first limiting member;
the at least one fan tray comprises:
a first fan tray, disposed in the second accommodating cavity, wherein a surface of a side of the first fan tray facing the third accommodating cavity is slidably engaged with the first limiting member; and
a second fan tray, disposed in the third accommodating cavity, wherein a surface of a side of the second fan tray facing the second accommodating cavity is slidably engaged with the first limiting member; and
a first gap exists between the first fan tray and the second fan tray, and the first limiting member is located in the first gap.

3. The heat dissipation architecture according to claim 2, wherein the at least one limiting member further comprises:
a second limiting member, located in the third accommodating cavity, wherein the second limiting member divides the third accommodating cavity into a fourth accommodating cavity and a fifth accommodating cavity along an extension direction of the second limiting member; and the second fan tray is located in the fourth accommodating cavity, and a surface of a side of the second fan tray facing the fifth accommodating cavity is slidably engaged with the second limiting member;
the at least one fan tray further comprises:
a third fan tray, wherein the third fan tray is located in the fifth accommodating cavity, and a surface of a side of the third fan tray facing the fourth accommodating cavity is slidably engaged with the second limiting member; and
a second gap exists between the second fan tray and the third fan tray, and the second limiting member is located in the second gap.

4. The heat dissipation architecture according to claim 1, wherein the at least one limiting member comprises:
a first limiting member, wherein the first limiting member divides the heat dissipation cavity into the second accommodating cavity and the third accommodating cavity along an extension direction of the first limiting member; and
the at least one fan tray comprises:
a first fan tray, disposed in the second accommodating cavity, wherein a side of the first fan tray facing the first cavity wall is provided with a first sliding groove; and the first limiting member is located in and engaged with the first sliding groove; and
a second fan tray, disposed in the third accommodating cavity, wherein a surface of a side of the second fan tray facing the second accommodating cavity is slidably engaged with the first limiting member.

5. The heat dissipation architecture according to claim 4, wherein a surface of the first fan tray facing the second fan tray abuts against a surface of the second fan tray facing the first fan tray.

6. The heat dissipation architecture according to claim 1, wherein the at least one limiting member comprises:
a first limiting member, wherein the first limiting member divides the heat dissipation cavity into the second accommodating cavity and the third accommodating cavity along an extension direction of the first limiting member; and
the at least one fan tray comprises:
a first fan tray, disposed in the second accommodating cavity, wherein a side of the first fan tray facing the first cavity wall is provided with a first recess portion; and
a second fan tray, disposed in the third accommodating cavity, wherein a side of the second fan tray facing the first cavity wall is provided with a second recess portion; the first recess portion and the second recess portion collectively form a second sliding groove; and the first limiting member is located in and engaged with the second sliding groove.

7. The heat dissipation architecture according to claim 1, wherein the at least one limiting member comprises:
a first limiting member, wherein the first limiting member divides the heat dissipation cavity into the second accommodating cavity and the third accommodating cavity along an extension direction of the first limiting member; and
a second limiting member, located in the third accommodating cavity, and the second limiting member divides the third accommodating cavity into a fourth accommodating cavity and a fifth accommodating cavity along an extension direction of the second limiting member; and
the at least one fan tray comprises:
a first fan tray, disposed in the second accommodating cavity and the fourth accommodating cavity, and located between the first limiting member and the second cavity wall, wherein the first fan tray is slidably engaged with a surface of the first limiting member facing the second cavity wall; and
a second fan tray, disposed in the fourth accommodating cavity and the fifth accommodating cavity, and located between the second limiting member and the second cavity wall, wherein the second fan tray is slidably engaged with a surface of the second limiting member facing the second cavity wall.

8. The heat dissipation architecture according to claim 7, wherein a side of the first fan tray facing the first cavity wall is provided with a third sliding groove, and the first limiting member is located in and engaged with the third sliding groove; and
a side of the second fan tray facing the first cavity wall is provided with a fourth sliding groove, and the second limiting member is located in and engaged with the fourth sliding groove.

9. The heat dissipation architecture according to claim 1, wherein the fan tray is disposed in the first accommodating cavity.

10. The heat dissipation architecture according to claim 1, wherein the fan tray comprises:
a first part, disposed in the first accommodating cavity; and
a second part, wherein a side of the second part facing the first cavity wall is provided with a fifth sliding groove, and the limiting member is located in and engaged with the fifth sliding groove.

11. The heat dissipation architecture according to claim 1, wherein the fan tray comprises:
a first fan assembly; and
a second fan assembly, wherein the first fan assembly and the second fan assembly are connected to each other on sides facing away from the heat dissipation cavity, and a third gap exists between the first fan assembly and the second fan assembly; and the limiting member is located in the third gap.

12. A heat dissipation architecture, comprising:
a heat dissipation frame body, having a heat dissipation cavity, wherein the heat dissipation frame body comprises a first cavity wall and a second cavity wall that are disposed opposite to each other; and the heat dissipation frame body is provided with a first air vent that communicates with the heat dissipation cavity; and
at least one limiting member, located in the heat dissipation cavity, wherein the limiting member is disposed on the first cavity wall; a first accommodating cavity is formed between the second cavity wall and a surface of a side of the limiting member facing away from the first cavity wall; and the limiting member divides the heat dissipation cavity into a second accommodating cavity and a third accommodating cavity along an extension direction of the limiting member.

13. A heat dissipation architecture, comprising:
a heat dissipation frame body, having a heat dissipation cavity, wherein the heat dissipation frame body comprises a first cavity wall and a second cavity wall that are disposed opposite to each other; and the heat dissipation frame body is provided with a first air vent that communicates with the heat dissipation cavity; and
at least one limiting member, located in the heat dissipation cavity, wherein a first end of the limiting member is detachably connected to the first cavity wall, and the limiting member divides the heat dissipation cavity into a second accommodating cavity and a third accommodating cavity along an extension direction of the limiting member.

14. A heat dissipation architecture, comprising:
a heat dissipation frame body, having a heat dissipation cavity, wherein the heat dissipation frame body comprises a first cavity wall and a second cavity wall that are disposed opposite to each other; and the heat dissipation frame body is provided with a first air vent that communicates with the heat dissipation cavity;
at least one limiting member, located in the heat dissipation cavity, wherein the limiting member is fixedly connected to the first cavity wall, a second end of the limiting member is connected to the second cavity wall, and the limiting member divides the heat dissipation cavity into a second accommodating cavity and a third accommodating cavity along an extension direction of the limiting member; and
a fan tray, located in the heat dissipation cavity, wherein the fan tray comprises:
a first fan assembly; and
a second fan assembly, wherein sides of the first fan assembly and the second fan assembly facing away from the heat dissipation cavity are connected to each other, and a third gap exists between the first fan assembly and the second fan assembly; and the limiting member is located in the third gap.

15. A subrack, comprising the heat dissipation architecture according to any one of claims 1 to 14, wherein the subrack further comprises:
a frame, wherein the heat dissipation architecture is disposed in the frame; and
a plurality of boards, disposed in the frame, the plurality of boards are all located on a same side of the heat dissipation architecture, a heat dissipation gap exists between adjacent boards, and the heat dissipation gap communicates with the first air vent.

16. A network device, comprising one or more subracks according to claim 15.

17. A communication system, comprising the network device according to claim 16, wherein the communication system further comprises a first access device, and the first access device is connected to the network device.
